# EUROPEAN PATENT APPLICATION

(11) **EP 3 376 621 A1**
(43) Date of publication of application: **19.09.2018**
(21) Application number: 17208197.8
(22) Date of filing: 18.12.2017
(51) Int. Cl.: H02H 3/14, H01H 83/02, H02H 3/16, H02H 3/05, H02H 3/33, H02H 7/20

(54) **DISTRIBUTED POWER SUPPLY**

(30) Priority: 13.03.2017 JP 2017047409
(71) Applicant: OMRON CORPORATION, Kyoto-shi, Kyoto 600-8530 (JP)
(72) Inventor: TSUBOTA, Yasuhiro, KYOTO, 600-8530 (JP); IWAMI, Taro, KYOTO, 600-8530 (JP)
(74) Representative: 2K Patentanwälte Blasberg Kewitz & Reichel

(57) **Abstract**

A distributed power supply that enables a user to easily determine whether or not a ground fault that has occurred is a received ground fault when a ground fault occurs is provided. A distributed power supply connected to a single-phase three-wire distribution line includes a power generation device (30), an alternating current generation circuit that generates an alternating current to be supplied between a W-phase wire and a U-phase wire of the single-phase three-wire distribution line on the basis of an output of the power generation device (30), a ground voltage detection circuit (25) that detects a ground voltage of a non-grounded portion in the alternating current generation circuit, and an output part (22) that outputs detection result information indicating a detection result of the ground voltage of the ground voltage detection circuit (25).

## Description

### BACKGROUND

### Technical Field

The disclosure relates to a distributed power supply.

### Description of Related Art

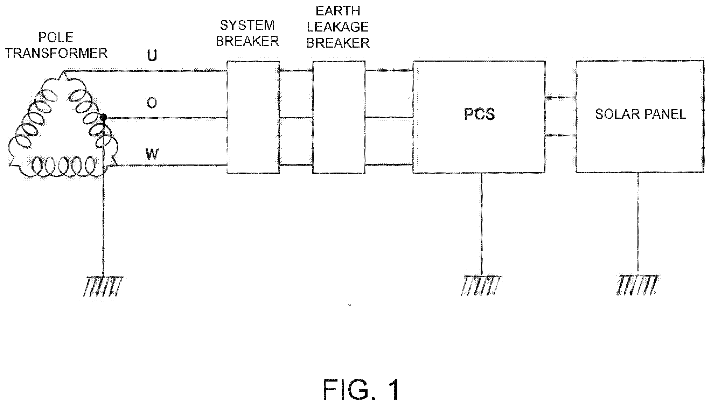

As illustrated in Fig. 1, a general distributed power supply (solar power generation system) in which a solar panel and a power conditioner (PCS) are combined is connected to a pole transformer via a system breaker and an earth leakage breaker.

When the earth leakage breaker trips, a ground fault (or earth leakage) has usually occurred in the distributed power supply. Therefore, when the earth leakage breaker trips, an operation of identifying the ground fault portion in the distributed power supply and resolving the ground fault is performed, but even when there is no ground fault in the distributed power supply, the earth leakage breaker may trip.

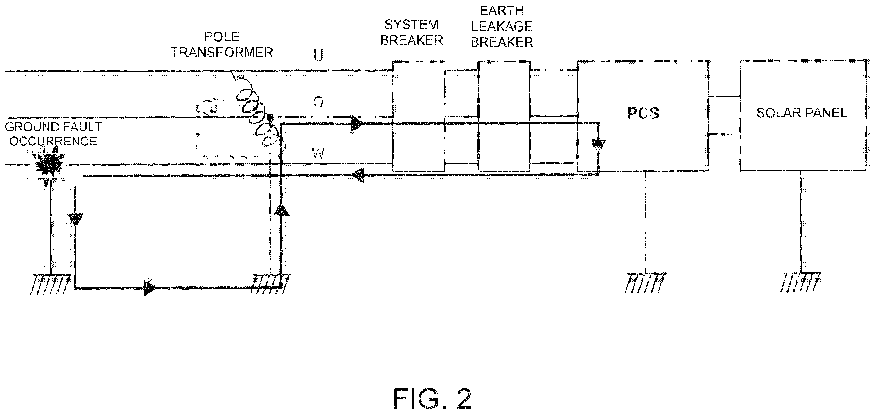

Specifically, as illustrated in Fig. 2, when a ground fault (ground fault of a W-phase in Fig. 2) occurs at a distant position, a phenomenon occurs in which a current flowing from a portion in which the ground fault has occurred to the ground flows into an O-phase wire via a ground wire and returns to the portion in which the ground fault has occurred via the inside of the PCS and a W-phase wire occurs. When such a phenomenon occurs, the earth leakage breaker detects an abnormal current and trips.

In an existing PCS, a ground fault detection circuit that detects a ground fault occurring in a distributed power supply is built into the PCS (for example, see Patent Document 1). However, since the ground fault detection circuit cannot detect the above phenomenon (hereinafter referred to as a received ground fault), time is taken for an operation of identifying the portion in which the ground fault has occurred when the earth leakage breaker trips due to the received ground fault.

[Patent Document 1] Japanese Unexamined Patent Application Publication No. 2012-119382

### SUMMARY

The present invention has been made in view of the above-described circumstances, and an object of the present invention is to provide a distributed power supply that enables a user (for example, a repair worker) to easily determine whether a ground fault that has occurred is a received ground fault when a ground fault occurs (for example, when a ground fault breaker trips).

In order to solve the above problem, a distributed power supply according to a first aspect of the present disclosure is a distributed power supply connected to a single-phase three-wire distribution line and includes a power generation device; an alternating current generation circuit that generates an alternating current to be supplied between a W-phase wire and a U-phase wire of the single-phase three-wire distribution line on the basis of an output of the power generation device; a ground voltage detection circuit that detects a ground voltage of a non-grounded portion in the alternating current generation circuit; and an output part that outputs detection result information indicating a detection result of the ground voltage of the ground voltage detection circuit.

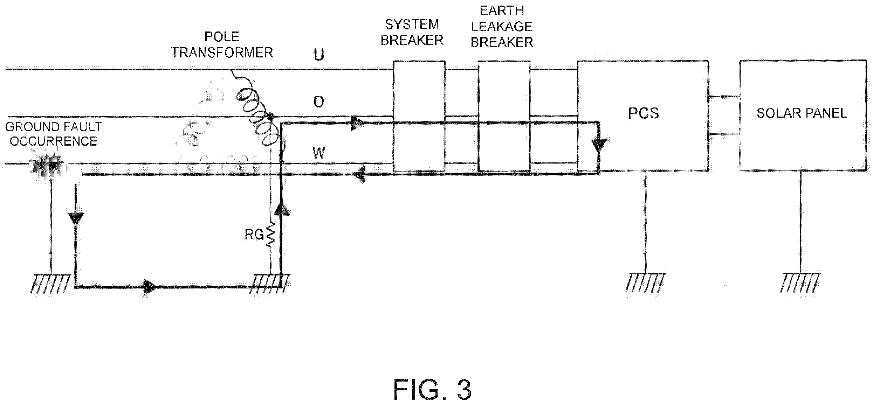

That is, as described above, when a received ground fault occurs, a current flows between an O-terminal of the pole transformer and the ground, but there is a ground resistor RG between the O-terminal of the pole transformer and the ground, as illustrated in Fig. 3. Therefore, when a received ground fault occurs, the ground voltage of the O-phase wire fluctuates, and as a result, "the ground voltage of the non-grounded portion in the AC generation circuit" also fluctuates. Since the distributed power supply according to a first aspect of the present invention includes the ground voltage detection circuit that monitors the ground voltage, and the output unit that outputs the detection result information indicating the detection result of the ground voltage of the ground voltage detection circuit, a user (a repair worker or the like) of the distributed power supply of the first aspect of the present invention can easily determine whether or not a ground fault that has occurred is a received ground fault on the basis of the detection result information output by the output unit when a ground fault occurs (for example, when the earth leakage breaker trips).

Further, in order to solve the above problem, a distributed power supply according to a second aspect of the disclosure is a distributed power supply connected to a single-phase three-wire distribution line, and includes: a ground voltage detection circuit that detects a ground voltage of an O-phase wire of the single-phase three-wire distribution line; and an output part that outputs detection result information indicating a detection result of the ground voltage of the ground voltage detection circuit.

That is, the distributed power supply according to the second aspect of the present invention has a configuration capable of outputting the detection result information indicating the detection result of the ground voltage of the O-phase wire. Since the ground voltage of the O-phase wire fluctuates when a received ground fault occurs (see Fig. 3), a user of the distributed power supply of the second aspect of the present invention can easily determine whether or not a ground fault that has occurred is a received ground fault on the basis of the detection result information output by the output unit when a ground fault occurs (for example, when the earth leakage breaker trips).

The detection result information output by the output unit of the distributed power supply according to each aspect of the present invention may be information from which the user can determine whether or not a ground fault that has occurred is a received ground fault. Therefore, the detection result information may be, for example, a fluctuation range of the ground voltage for the latest predetermined time period detected by the ground voltage detection circuit or an effective value of an alternating current component in a pattern of change over time of the ground voltage for the latest predetermined time. Further, the detection result information may be a determination result as to whether or not a received ground fault has occurred. Further, the output unit may output the detection result information through a display on the display or may output the detection result information through storage in a memory accessible to a device in the distributed power supply or a device outside the distributed power supply.

In the distributed power supply according to the second aspect of the present invention, a configuration in which the alternating current generation circuit includes an inverter for converting a direct current into an alternating current to be supplied between a W-phase wire and a U-phase wire of the single phase three wire distribution line, and a non-grounded portion in the alternating current generation circuit is one of a pair of distribution lines for supplying a direct current to the inverter may be adopted.

Further, various ground voltage detection circuits having different specific configurations can be adopted as the ground voltage detection circuit of the distributed power supply of each aspect of the present invention. For example, a differential amplifier circuit which amplifies a potential difference between the non-grounded portion in the alternating current generation circuit and the ground can be adopted as the ground voltage detection circuit.

In order to enable the ground voltage to be accurately detected (in order to prevent a voltage caused by noise in the voltage from being output), an isolation amplifier that amplifies a potential difference between the non-grounded portion in the alternating current generation circuit and the ground, or a circuit including an isolation transformer including a primary side connected to the non-grounded portion in the alternating current generation circuit and the ground, and a differential amplifier circuit that amplifies an output of the isolation transformer may be adopted as the ground voltage detection circuit. In a ground voltage detection circuit including an isolation transformer, a configuration in which the isolation transformer is connected to the non-grounded portion in the alternating current generation circuit or the ground via a capacitor for direct current component removal may be adopted.

According to the present invention, it is possible to provide a distributed power supply that enables a user to easily determine whether or not a ground fault that has occurred is a received ground fault when a ground fault occurs.

### BRIEF DESCRIPTION OF THE DRAWINGS

Fig. 1 is an illustrative diagram of a form of connection to a pole transformer of a general distributed power supply (solar power generation system).
Fig. 2 is an illustrative diagram of a received ground fault.
Fig. 3 is an illustrative diagram of a function of a distributed power supply of the disclosure.
Fig. 4 is an illustrative diagram of a schematic configuration and a form of use of a distributed power supply according to a first embodiment of the disclosure.
Fig. 5 is an illustrative diagram of a circuit that is usable as a ground voltage detection circuit of the distributed power supply according to the first embodiment.
Fig. 6 is an illustrative diagram of a circuit that is usable as the ground voltage detection circuit of the distributed power supply according to the first embodiment.
Fig. 7 is an illustrative diagram of a circuit that is usable as the ground voltage detection circuit of the distributed power supply according to the first embodiment.
Fig. 8 is a diagram illustrating a function of the distributed power supply according to the first embodiment.
Fig. 9 is a diagram illustrating the function of the distributed power supply according to the first embodiment.
Fig. 10 is an illustrative diagram of a schematic configuration and a form of use of a distributed power supply according to a second embodiment of the disclosure.
Fig. 11 is an illustrative diagram of a circuit that is usable as a ground voltage detection circuit of the distributed power supply according to the second embodiment.
Fig. 12 is an illustrative diagram of a circuit that is usable as the ground voltage detection circuit of the distributed power supply according to a second embodiment.
Fig. 13 is an illustrative diagram of a circuit that is usable as the ground voltage detection circuit of the distributed power supply according to the second embodiment.

### DESCRIPTION OF THE EMBODIMENTS

Hereinafter, modes for carrying out the disclosure will be described in detail by way of example with reference to the drawings.

### <<First Embodiment>>

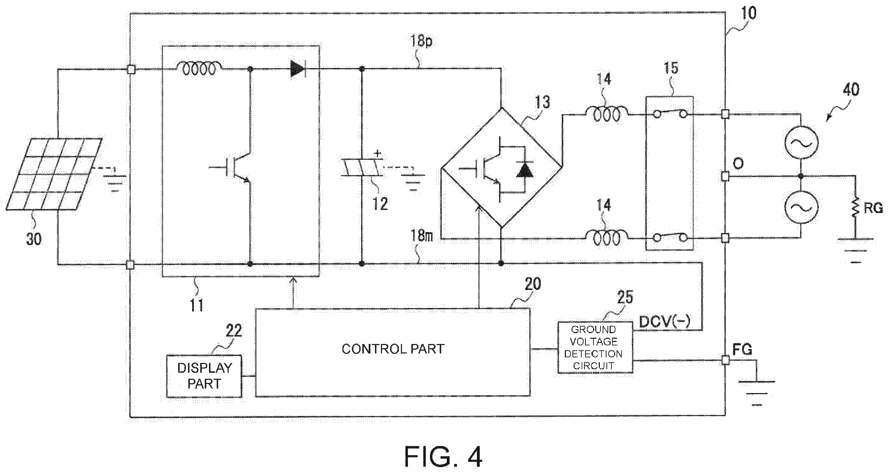

Fig. 4 illustrates a schematic configuration and a form of use of a distributed power supply according to a first embodiment of the disclosure.

The distributed power supply according to this embodiment is a device in which a solar panel 30 and a power conditioner (hereinafter referred to as a PCS) 10 are combined.

The PCS 10 is a single phase output PCS that is connected to a pole transformer 40 by a single-phase three-wire distribution line. The PCS 10 includes a DC/DC converter 11, a DC/AC inverter 13, a control part 20, a display part 22, and a ground voltage detection circuit 25.

The DC/DC converter 11 (hereinafter also referred to as a converter 11) is a boosting chopper circuit for boosting a direct current voltage from the solar panel 30. The DC/AC inverter 13 (hereinafter also referred to as an inverter 13) is a circuit for converting the direct current voltage from the converter 11 to an alternating current voltage. As illustrated in Fig. 4, each output terminal of the converter 11 is connected to a W-phase wire or a U-phase wire of the single-phase three-wire distribution line via an AC reactor 14 and an interconnection relay 15. A capacitor 12 for smoothing a supply voltage to be supplied to the inverter 13 is provided between a pair of distribution lines 18p and 18m for supplying the direct current voltage from the converter 11 to the inverter 13. The distribution line 18p is a distribution line on the high potential side (positive side), and the distribution line 18m is a distribution line on the low potential side (negative side).

The ground voltage detection circuit 25 is a circuit that detects a ground voltage of a voltage DCV(-) of the distribution line 18m (in this embodiment, a voltage with respect to a frame ground FG).

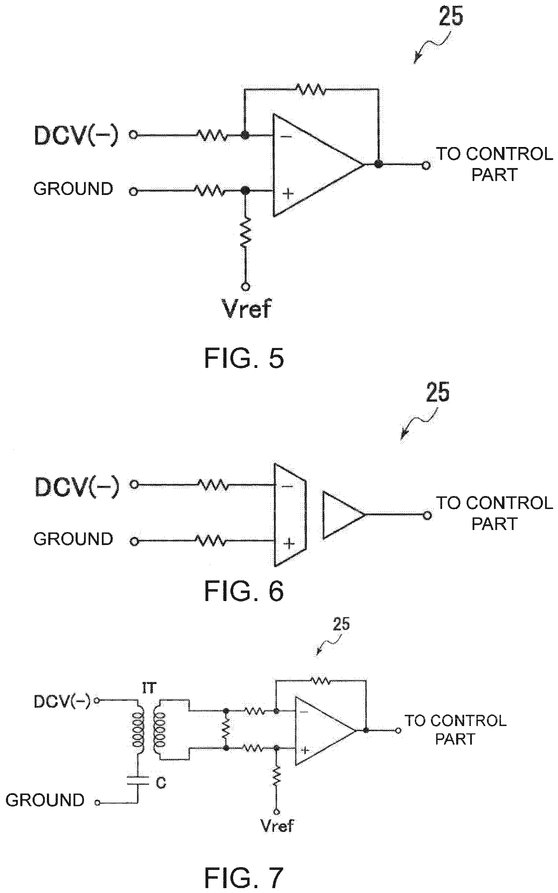

Various circuits can be used as the ground voltage detection circuit 25. For example, a circuit illustrated in Fig. 5, that is, a differential amplifier circuit that amplifies a potential difference between DCV(-) and the ground can be used as the ground voltage detection circuit 25. Further, a circuit illustrated in Fig. 6, that is, an isolation amplifier that amplifies the potential difference between DCV(-) and the ground can also be used as the ground voltage detection circuit 25.

As illustrated in Fig. 7, a circuit in which a capacitor C, an isolation transformer IT, and a differential amplifier circuit are combined can be used as the ground voltage detection circuit 25. The capacitor C in this ground voltage detection circuit 25 (Fig. 7) is a capacitor that removes a direct current component. When an absolute value of DCV(-) is small, etc., the DCV(-) and the ground may be directly connected in a primary side of the isolation transformer IT.

When an input and an output are not isolated, a voltage caused by noise in the voltage is output from the amplifier, and therefore, the ground voltage detection circuit 25 (Figs. 6 and 7) in which the input and the output are isolated can normally detect the ground voltage more accurately than the ground voltage detection circuit 25 (Fig. 5) in which the input and the output are not isolated. Further, when the input and output are isolated, it is possible to protect a circuit (control part 20) in a subsequent stage. Therefore, from such a viewpoint, the ground voltage detection circuit 25 in which the input and the output are isolated may be adopted.

The display part 22 (Fig. 4) is an LCD display that is attached to a casing of the PCS 10 and is capable of displaying text. The control part 20 is a device (unit) that integrally controls each part in the PCS 10. The control part 20 includes a processor, a flash ROM, a RAM, a gate driver, an interface for communication with another device (computer), and the like.

The control that the control part 20 performs on respective parts (the converter 11, the inverter 13, and the interconnection relay 15) is the same as the control that a control part in a general PCS performs on respective parts. That is, the control part 20 controls the converter 11 so that a maximum power is extracted from the solar panel 30, and controls the inverter 13 so that an alternating current having the same phase as that of the system is output. Further, when a trip of a ground fault breaker (not illustrated), an electricity supply failure, or the like occurs, the control part 20 turns off the interconnection relay 15 and stops operations of the converter 11 and the inverter 13.

However, the control part 20 is configured (programmed) to perform the following process on the basis of an output of the ground voltage detection circuit 25.

The control part 20 always monitors whether a fluctuation range of the output of the ground voltage detection circuit 25 has become larger than a threshold width. Here, the threshold width is a value that is preset as a lower limit value of a fluctuation range in which a received ground fault is likely to occur.

When the fluctuation range of the output of the ground voltage detection circuit 25 becomes larger than the threshold width, the control part 20 stores fluctuation range information including the fluctuation range and present date and time in the flash ROM in the control part 20, and displays a message indicating that a received ground fault is likely to occur on the display part 22. When the number of pieces of fluctuation range information in the flash ROM is a predetermined number, the control part 20 rewrites the oldest fluctuation range information on the flash ROM as current fluctuation range information. The control part 20 then starts monitoring the fluctuation range of the output of the ground voltage detection circuit 25 again.

Further, the control part 20 is configured to also transmit each (all) piece of fluctuation range information on the flash ROM to another device when the control part 20 receives a predetermined request from a computer connected to the communication interface.

Hereinafter, a reason for adoption of the above configuration in the distributed power supply according to this embodiment will be described. As described above, when a received ground fault occurs, a current flows between the O-terminal of the pole transformer and the ground, but there is a ground resistor RG between the O-terminal of the pole transformer and the ground. Therefore, when a received ground fault occurs, the ground voltage of the O-phase wire fluctuates, and as a result, DCV(-) also fluctuates.

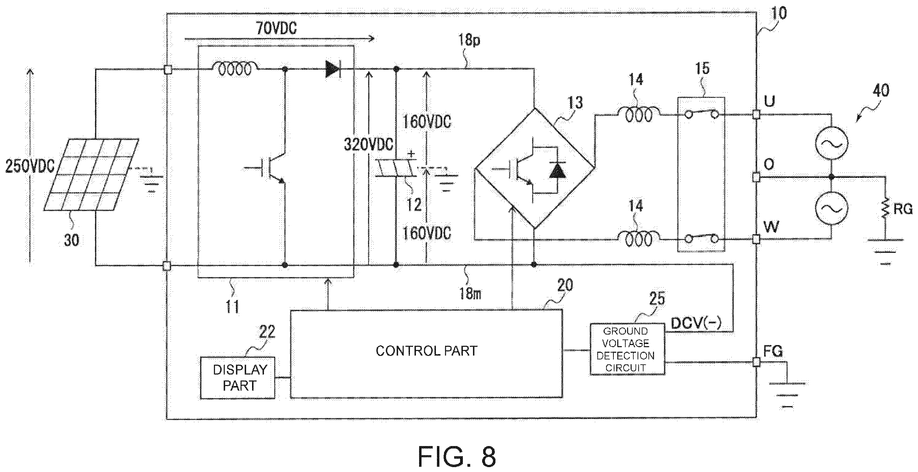

Specifically, a situation in which the output voltage of the solar panel 30 is 250 V and the output voltage is boosted by 70 V by the converter 11 as illustrated in Fig. 8 is considered. In this situation, DCV(-) becomes -160 V when a received ground fault does not occur.

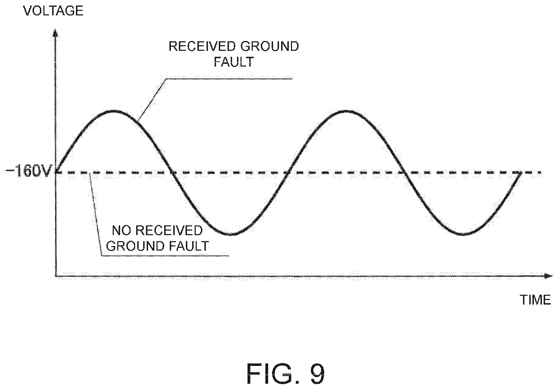

On the other hand, when a received ground fault occurs, DCV(-) also fluctuates as illustrated in Fig. 9 since the ground voltage of the O-phase wire fluctuates. However, a fluctuation range changes according to a magnitude of the ground resistor RG and a value of a current actually flowing through the portion in which a received ground fault has occurred. Therefore, it cannot be determined whether or not the received ground fault has occurred only from the fluctuation range, but it can be determined whether the received ground fault is likely to occur from the fluctuation range when there is other information (for example, information indicating that the earth leakage breaker has tripped, but a ground fault has not been detected in the ground fault detection circuit). Therefore, as described above, the ground voltage detection circuit 25 is provided in the PCS 10, and the control part 20 is configured so that, when the fluctuation range of the output of the ground voltage detection circuit 25 becomes larger than the threshold width, fluctuation range information including the fluctuation range and the present date and time is stored in the flash ROM in the control part 20, and a message indicating that a received ground fault is likely to occur is displayed on the display part 22.

### <<Second Embodiment>>

Hereinafter, a configuration and an operation of a distributed power supply according to a second embodiment of the disclosure will be described with a focus on parts different from the distributed power supply according to the first embodiment described above.

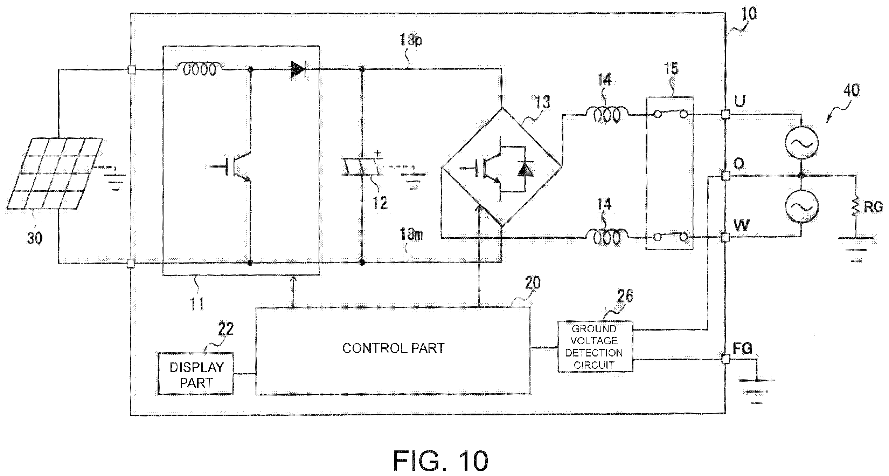

Fig. 10 illustrates a schematic configuration and a form of use of the distributed power supply according to the second embodiment of the disclosure. The distributed power supply according to this embodiment is obtained by replacing the ground voltage detection circuit 25 (Fig. 4) of the distributed power supply according to the first embodiment with a ground voltage detection circuit 26.

As illustrated in Fig. 10, the ground voltage detection circuit 26 is a circuit that detects a ground voltage of an O-phase wire of a single-phase three-wire distribution line (a voltage with respect to FG in this embodiment).

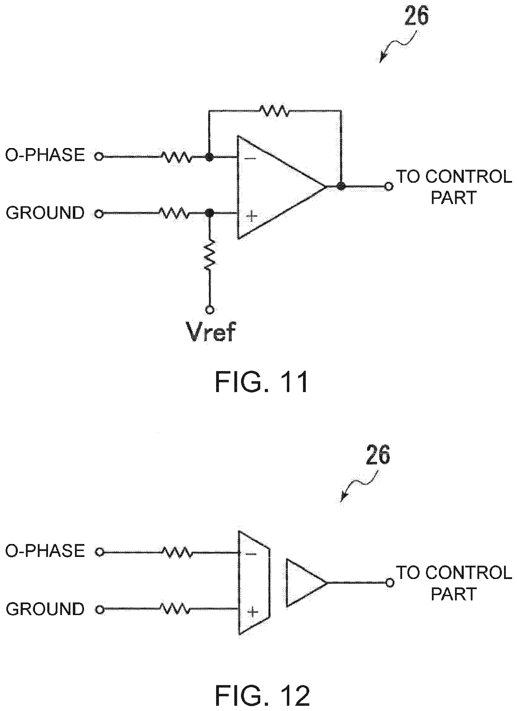

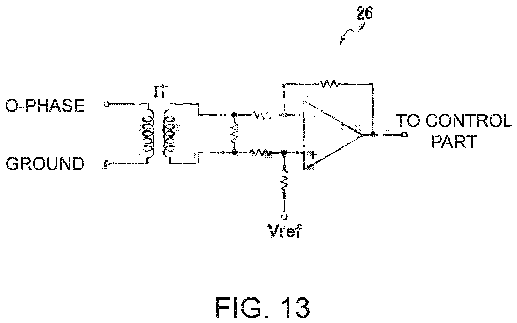

Various circuits can be used as the ground voltage detection circuit 26. For example, a circuit illustrated in Fig. 11, that is, a differential amplifier circuit that amplifies a potential difference between the O-phase wire and the ground can be used as the ground voltage detection circuit 26. Further, a circuit illustrated in Fig. 12, that is, an isolation amplifier that amplifies the potential difference between the O-phase wire and the ground can be used as the ground voltage detection circuit 26. As illustrated in Fig. 13, a circuit in which an isolation transformer IT and a differential amplifier circuit are combined can be used as the ground voltage detection circuit 26.

As is apparent from the above description, the distributed power supply according to this embodiment has a configuration in which, for example, a message indicating that a received ground fault is likely to occur on the basis of the ground voltage of the O-phase wire is displayed on a display part 22. When a received ground fault occurs, the ground voltage of the O-phase wire fluctuates. Therefore, when a ground fault occurs, a user of the distributed power supply according to this embodiment can also easily determine whether or not a generated ground fault is a received ground fault from the message displayed on the display part 22 or a fluctuation range read by a computer.

### <<Modification Example>>

The distributed power supply of each of the embodiments described above can be variously modified. For example, the ground voltage detection circuit 25 of the distributed power supply according to the first embodiment may be modified into a circuit that detects a ground voltage of another non-grounded portion (for example, the distribution line 18p) in a circuit (for example, a circuit including the converter 11 and the inverter 13 as main components) that generates an alternating current to be supplied between the W-phase wire and the U-phase wire of the single-phase three-wire distribution line in the PCS 10. The control part 20 in the distributed power supply of each embodiment may be modified into a control part that changes the message to be displayed on the display part 22 according to a magnitude of the fluctuation range of the ground voltage. Further, the control part 20 in the distributed power supply of each embodiment may be modified into a control part that stores, for example, an effective value of an alternating current component in a pattern of change over time of the ground voltage instead of the fluctuation range of the ground voltage.

It is to be understood that the distributed power supply of each embodiment may be modified into a distributed power supply (for example, a distributed power supply including a power generation device other than the solar panel 30) of which the specific hardware configuration is different from the above-described configurations.

### [Explanation of sign]

10: power conditioner (PCS), 11: DC/DC converter, 12: capacitor, 13: DC/AC inverter, 14: AC reactor, 20: control part, 22: display part, 25, 26: ground voltage detection circuit, 30: solar panel, 40: pole transformer

## Claims

1. A distributed power supply connected to a single-phase three-wire distribution line, the distributed power supply comprising:
a power generation device (30);
an alternating current generation circuit that generates an alternating current to be supplied between a W-phase wire and a U-phase wire of the single-phase three-wire distribution line on the basis of an output of the power generation device (30);
a ground voltage detection circuit (25) that detects a ground voltage of a non-grounded portion in the alternating current generation circuit; and
an output part (22) that outputs detection result information indicating a detection result of the ground voltage of the ground voltage detection circuit (25).

2. A distributed power supply connected to a single-phase three-wire distribution line, the distributed power supply comprising:
a ground voltage detection circuit (26) that detects a ground voltage of an O-phase wire of the single-phase three-wire distribution line; and
an output part (22) that outputs detection result information indicating a detection result of the ground voltage of the ground voltage detection circuit (26).

3. The distributed power supply according to claim 1,
wherein the alternating current generation circuit includes an inverter (13) for converting a direct current into an alternating current to be supplied between a W-phase wire and a U-phase wire of the single phase three wire distribution line, and
the non-grounded portion in the alternating current generation circuit is a distribution line in the alternating current generation circuit and the distribution line is one of a pair of distribution lines (18p, 18m) for supplying a direct current to the inverter (13).

4. The distributed power supply according to any one of the claims 1 to 3,
wherein the ground voltage detection circuit (25, 26) is a differential amplifier circuit which amplifies a potential difference between the non-grounded portion in the alternating current generation circuit and the ground.

5. The distributed power supply according to any one of the claims 1 to 3,
wherein the ground voltage detection circuit (25, 26) is an isolation amplifier that amplifies a potential difference between the non-grounded portion in the alternating current generation circuit and the ground.

6. The distributed power supply according to any one of claims 1 to 3,
wherein the ground voltage detection circuit (25, 26) includes
an isolation transformer (IT) including a primary side, the primary side being connected to the non-grounded portion in the alternating current generation circuit and the ground, and
a differential amplifier circuit that amplifies an output of the isolation transformer (IT).

7. The distributed power supply according to claim 6,
wherein the isolation transformer (IT) of the ground voltage detection circuit (25, 26) is connected to the non-grounded portion in the alternating current generation circuit or the ground via a capacitor (C) for direct current component removal.
